# EUROPÄISCHE PATENTSCHRIFT

(11) **EP 3 667 352 B1**
(45) Veröffentlichungstag und Bekanntmachung des Hinweises auf die Patenterteilung: **30.03.2022**
(21) Anmeldenummer: 18211350.6
(22) Anmeldetag: 10.12.2018
(51) Int. Cl.: G01R 33/56, G01R 33/32, G01R 33/565

(54) **VERFAHREN ZUM VERBESSERN DER BILDQUALITÄT EINES MAGNETRESONANZBILDES DURCH BERÜCKSICHTIGUNG VON FREQUENZGANGDATEN**
METHOD FOR IMPROVING THE IMAGE QUALITY OF A MAGNETIC RESONANCE IMAGE BY USING FREQUENCY RESPONSE DATA
PROCÉDÉ PERMETTANT D'AMÉLIORER LA QUALITÉ D'IMAGE D'UNE IMAGE À RÉSONANCE MAGNÉTIQUE EN UTILISANT DES DONNÉES DE RÉPONSE DE FRÉQUENCE

(43) Veröffentlichungstag der Anmeldung: 17.06.2020
(73) Patentinhaber: Siemens Healthcare GmbH, 91052 Erlangen (DE)
(72) Erfinder: Biber, Stephan, 91056 Erlangen (DE)

(56) Entgegenhaltungen:
- DE-A1-102017 200 446
- US-A1- 2007 182 410
- O. JOSEPHS ET AL.: "Correction of EPI Nyquist ghosting caused by the non-uniform frequency response of the MRI receiver chain", PROCEEDINGS OF THE INTERNATIONAL SOCIETY FOR MAGNETIC RESONANCE IN MEDICINE, 14TH SCIENTIFIC MEETING AND EXHIBITION, SEATTLE, WASHINGTON, USA, 6-12 MAY 2006, 22. April 2006 (2006-04-22), XP040596261,
- M. I. HROVAT ET AL.: "Signal Correction for Narrow-Bandwidth Coils", PROCEEDINGS OF THE INTERNATIONAL SOCIETY FOR MAGNETIC RESONANCE IN MEDICINE, ISMRM, 11TH SCIENTIFIC MEETING AND EXHIBITION, TORONTO, CANADA, 10-16 JULY 2003, 26. Juni 2003 (2003-06-26), XP040588392,

## Beschreibung

Verfahren und Magnetresonanzanlage zum Verbessern einer Bildqualität eines Magnetresonanzbildes und entsprechendes computerlesbares Speichermedium

Die Erfindung betrifft ein Verfahren und eine Magnetresonanzanlage zum Verbessern einer Bildqualität eines Magnetresonanzbildes. Weiterhin betrifft die Erfindung ein entsprechendes computerlesbares Speichermedium, auf welchem ein das Verfahren kodierendes Computerprogramm gespeichert ist.

Die Magnetresonanzbildgebung ist mittlerweile ein etabliertes bildgebendes Verfahren. Systeme zur Durchführung einer Magnetresonanzbildgebung sind beispielsweise in US20170045597A1 oder US20180172792A1 beschrieben. Es wird jedoch weiter nach Verbesserungen gestrebt, welche zu einer Verbesserung einer Bildqualität von Magnetresonanzbildern führen oder beitragen können. Dabei gibt es vielfältige Ansatzpunkte und noch nicht gelöste Probleme. Ein solches Problem besteht darin, dass, insbesondere bei Niederfeldsystemen mit statischen Magnetfeldstärken von 1,5 T oder weniger, Bandbreiten von Sende- und Empfangssystemen oder -einrichtungen, also beispielsweise entsprechenden Spulen oder Antennen, signifikant schmaler sind als bei Hochfeldsystemen, also Magnetresonanzanlagen mit einer statischen Magnetfeldstärke von mehr als 1,5 T. Zu diesem Problem trägt bei, dass in Niederfeldsystemen entsprechende Güten vergleichsweise sehr hoch sind, da - beispielsweise aufgrund einer größeren Scantiefe - weniger ohmsche Verluste und niedrigere Objekt- oder Patientenverluste, also Verluste in einem abzubildenden oder zu untersuchenden Untersuchungsobjekt, auftreten. Letzteres wiederum ist bedingt durch eine typischerweise niedrigere Leitfähigkeit von biologischem Gewebe bei niedrigeren Frequenzen.

Eine geringere statische Magnetfeldstärke (B-Feldstärke) ist dabei über das gyromagnetische Verhältnis γ, mit einer entsprechend niedrigeren Frequenz verknüpft. Letztlich ist als Effekt eine Frequenzabhängigkeit von gesendeten und empfangenen oder gemessenen Signalen zu beobachten, welche umso ausgeprägter ist, je geringer die Bandbreite und je geringer die verwendete statische Magnetfeldstärke ist. Eine derartige Frequenzabhängigkeit, auch als nicht-flacher Frequenzgang, beispielsweise einer Signalamplitude und/oder einer Signalphase, bezeichnet, kann beispielsweise zu Helligkeitsschwankungen in Frequenzkodierrichtung in dem jeweiligen resultierenden Magnetresonanzbild führen.

Ebenso kann in Schichten des Untersuchungsobjekts, welche in einem Randbereich eines Aufnahmeraumes oder Aufnahmevolumens liegen und damit weiter von einer vorgegebenen Mittenfrequenz entfernt sind, nicht ausreichend B₁-Amplitude verfügbar, erreichbar oder gegeben sein, um beispielsweise über einen gesamten Bildbereich hinweg einen gleichmäßigen Kontrast zu erreichen. Somit kann es also in dem letztendlich resultierenden Magnetresonanzbild auch zu einer Schwankung des Kontrasts in Schichtrichtung kommen.

Bisherige Lösungsansätze beschränken sich soweit überhaupt vorhanden lediglich darauf, durch Verwendung qualitativ hochwertiger Hardwarekomponenten einen möglichst konsistenten Frequenzgang zu erreichen.

In der Veröffentlichung von O. Josephs et al., "Correction of EPI Nyquist ghosting caused by the non-uniform frequency response of the MRI receiver chain", in Proceedings of 14th ISMRM, 2006, Nr. 744, wird ein Verfahren zur Korrektur von Bildartefakten in Magnetresonanzbildern offenbart, welche durch eine uneinheitliche Frequenzantwort einer Empfangskette der Magnetresonanzanlage verursacht werden. Des Weiteren wird in der Veröffentlichung von M. I. Hrovat et al., "Signal Correction for Narrow-Bandwidth Coils", in Proceedings of 11th ISMRM, 2003, Nr. 1053, ein Verfahren zur Bandbreitenkorrektur von schmalbandigen Spulen basierend auf einer gemessenen Frequenzantwort offenbart. Die Patentschrift US 2007/0182410 A1 offenbart ein Verfahren zur Reduktion von Bildartefakten in Magnetresonanzbildern mittels einer Abschätzung der Empfindlichkeitsverteilung einer Spule bei einer parallelen Bildgebungssequenz. Ferner offenbart das Dokument DE 102017200446 A1 eine Methode zur Korrektur eines Sendesignals einer Magnetresonanzanlage basierend auf einer ermittelten frequenzabhängigen Übertragungsfunktion eines Sendesystems.

Aufgabe der vorliegenden Erfindung ist es, eine verbesserte Bildqualität von Magnetresonanzbildern zu ermöglichen. Diese Aufgabe wird erfindungsgemäß durch die Gegenstände der unabhängigen Patentansprüche gelöst. Vorteilhafte Ausgestaltungen und Weiterbildungen der vorliegenden Erfindung sind in den abhängigen Patentansprüchen, in der Beschreibung und in den Figuren angegeben.

Ein erfindungsgemäßes Verfahren dient zum Verbessern einer Bildqualität eines Magnetresonanzbildes. Dabei werden Magnetresonanzdaten eines Untersuchungsobjekts, beispielsweise eines Patienten oder eines Teilbereichs eines Patienten, erfasst, welche mittels einer Magnetresonanzanlage gemäß einer vorgegebenen Messsequenz aufgenommen wurden. Die Magnetresonanzanlage kann beispielsweise ein Magnetresonanztomograph (MRT) sein.

Das Erfassen der Magnetresonanzdaten kann dabei deren Empfangen oder Einlesen oder Speichern oder Zwischenspeichern ebenso bedeuten oder umfassen wie beispielsweise ein Abrufen der Magnetresonanzdaten von oder aus einem elektronischen Speicher.

Weiter werden bei dem Verfahren separat von der Messsequenz, insbesondere separat von der Erfassung der Magnetresonanzdaten gemäß der vorgegebenen Messsequenz, Frequenzgangdaten für ein Subsystem der Magnetresonanzanlage erfasst. Diese Frequenzgangdaten geben dabei einen Frequenzgang oder ein Frequenzverhalten des Subsystems an. Insbesondere können die Frequenzgangdaten eine Frequenzabhängigkeit einer Signalamplitude und/oder einer Signalphase angeben, beispielsweise in Form entsprechender Messdaten, einer Tabelle und/oder einer Funktion.

In einem weiteren Verfahrensschritt des erfindungsgemäßen Verfahrens wird anhand der Frequenzgangdaten eine Frequenzgangkorrektur für die Magnetresonanzdaten oder von Prescandaten, welche bei einer Rekonstruktion des Magnetresonanzbildes aus den Magnetresonanzdaten berücksichtigt werden, insbesondere automatisch oder teilautomatisch, durchgeführt. Aus den korrigierten Magnetresonanzdaten können ein Magnetresonanzbild rekonstruiert werden und/oder die korrigierten Prescandaten können bei der einer Rekonstruktion des Magnetresonanzbildes aus den Magnetresonanzdaten berücksichtigt werden. Das rekonstruierte Magnetresonanzbild kann, beispielsweise auf einem Bildschirm, angezeigt werden.

Durch die Frequenzgangkorrektur wird die Frequenzabhängigkeit korrigiert oder ausgeglichen, der Frequenzgang also geglättet. Mit anderen Worten wird die Frequenzabhängigkeit also zumindest im Wesentlichen eliminiert, sodass der Frequenzgang des Subsystems sich nicht auf das Magnetresonanzbild oder dessen Bildqualität auswirkt. Dazu können die Magnetresonanzdaten beispielsweise durch die Frequenzgangdaten dividiert werden oder mit einem aus den Frequenzgangdaten abgeleiteten Korrekturfaktor multipliziert oder gewichtet werden, sodass lediglich ein tatsächliche Eigenschaften des jeweiligen Untersuchungsobjekts widerspiegelnder Anteil verbleibt.

Wie die Frequenzgangdaten gewonnen und gehandhabt werden können, wird weiter unten näher erläutert.

Die Prescandaten können beispielsweise mittels eines Prescan, also eines vor der Messsequenz durchgeführten Vorabscans des Untersuchungsobjekts gewonnen und/oder beispielsweise ebenfalls aus einem entsprechenden elektronischen Speicher abgerufen werden. Da die Prescandaten bei dem Rekonstruieren oder Erzeugen des Magnetresonanzbildes ohnehin berücksichtigt werden, kann die Frequenzgangkorrektur ebenso auf diese Prescandaten angewendet werden, wodurch sie dann indirekt auch in das Magnetresonanzbild oder dessen Rekonstruktion mit einfließt.

Das Durchführen eines Prescan ist ein in der Magnetresonanzbildgebung an sich bekanntes Vorgehen, das beispielsweise zur Kalibrierung dient, um eine bestmögliche Durchführung einer nachfolgenden Messsequenz zu gewährleisten. Dabei können beispielsweise räumliche Abhängigkeiten oder Variationen einer Empfindlichkeit, Messgenauigkeit oder Signalstärke über den Aufnahmebereich oder das Aufnahmevolumen hinweg für eine entsprechende Korrektur erfasst werden. Dies kann beispielsweise vorteilhaft sein, wenn die Magnetresonanzdaten mittels eines Rasters oder Arrays mehrerer auf oder an dem Untersuchungsobjekt räumlich verteilt angeordneter Lokalspulen gemessen werden. Die vorliegende Erfindung sieht darüber hinaus jedoch vor, zusätzlich auch die Frequenzabhängigkeit nigstens einer Lokalspule (LC, englisch: local coil), und optional eines Sendersystems, also beispielsweise einer das Untersuchungsobjekt beziehungsweise den Aufnahmeraum umgebenden Körperspule (BC, englisch: body coil), zu berücksichtigen und zu korrigieren, um eine weitere Verbesserung der Bildqualität resultierender Magnetresonanzbilder zu erreichen.

Die Frequenzgangkorrektur kann beispielsweise durch einen integrierten Schaltkreis, etwa ein FPGA oder dergleichen, eines Analog- oder Digitalempfängers und/oder einer entsprechenden Steuereinheit des Sendersystems der Magnetresonanzanlage durchgeführt werden. Besonders bevorzugt kann die Frequenzgangkorrektur aber in Software, beispielsweise durch eine entsprechende Betriebssoftware, eines Bildrekonstruktionscomputers durchgeführt werden. Letzteres ermöglicht dabei vorteilhaft eine verbesserte Flexibilität oder Anpassbarkeit der Frequenzgangkorrektur beziehungsweise des hier vorgeschlagenen Verfahrens. Der Bildrekonstruktionscomputer kann dabei beispielsweise Teil einer Datenverarbeitungseinrichtung der Magnetresonanzanlage oder mit dieser direkt oder indirekt verbunden sein.

Für den Begriff "Magnetresonanz" wird vorliegend auch die Abkürzung "MR" verwendet beispielsweise bezeichnet der Begriff "MR-Daten" dann also die genannten Magnetresonanzdaten und die Magnetresonanzanlage kann auch als MR-Anlage oder als MRT bezeichnet werden.

Ferner umfasst das Subsystem eine tauschbare Spule, insbesondere eine Lokalspule, welche für eine Verwendung mit verschiedenen Magnetresonanzanlagen ausgebildet ist. Die verschiedenen Magnetresonanzanlagen können dabei insbesondere baugleiche Magnetresonanzanlagen, also eines gleichen Typs und/oder Modells, sein.

Die Frequenzgangdaten werden hier also für eine tauschbare Spule oder für eine Anordnung oder eine Baugruppe aus mehreren Komponenten, von denen die tauschbare Spule eine ist, erfasst. Dass die Spule tauschbar und für die Verwendung mit verschiedenen Magnetresonanzanlagen ausgebildet ist, kann dabei insbesondere bedeuten, dass die Spule nicht fest mit der Magnetresonanzanlage verbunden ist, sondern beispielsweise beschädigungsfrei reversibel von dieser lösbar oder nur über eine kabellose Daten- oder Signalverbindung mit der Magnetresonanzanlage verbunden ist. Beispielsweise kann die Spule eingesteckt oder eingeschraubt sein oder einen Anschluss, also beispielsweise einen Stecker oder eine Buchse, aufweisen und darüber durch ein Anschlusskabel mit der Magnetresonanzanlage verbunden sein. Die Spule kann also separat von der eigentlichen oder übrigen Magnetresonanzanlage transportabel sein. In einem solchen Fall kann die vorliegende Erfindung besonders vorteilhaft und nutzbringend angewendet werden, da aufgrund der Austauschbarkeit der Spule und deren Verwendung oder Verwendbarkeit in den unterschiedlichen Magnetresonanzanlagen nicht von einer detaillierten Abstimmung von elektrischen oder Übertragungseigenschaften der tauschbaren Spule und den übrigen Komponenten der Magnetresonanzanlage ausgegangen werden kann. Daher kann es dann zu unvorhergesehenen und nicht im Vorhinein, beispielsweise durch einen Hersteller dauerhaft kompensierbaren Frequenzabhängigkeiten oder sonstigen Einflüssen auf ein elektrisches Verhalten oder ein Signalverhalten der Spule und/oder der Magnetresonanzanlage kommen. Diese Probleme werden durch die vorliegend vorgesehene Frequenzgangkorrektur automatisch für praktisch beliebige Kombinationen von tauschbaren Spulen und Magnetresonanzanlagen gelöst.

In weiterer vorteilhafter Ausgestaltung der vorliegenden Erfindung umfasst die tauschbare Spule einen Datenspeicher. Die Frequenzgangdaten werden in diesem Datenspeicher der tauschbaren Spule abgelegt und zum Durchführen der Frequenzgangkorrektur aus dem Datenspeicher abgerufen, beispielsweise bei einem Verbinden der Spule mit der Magnetresonanzanlage. Die Frequenzgangdaten für die spezifische Spule werden also in einer diese Spule umfassenden Spuleneinheit selbst gespeichert und liegen dadurch vorteilhaft stets gemeinsam mit der jeweiligen Spule vor. Da somit die Frequenzgangdaten einmalig für die jeweilige individuelle Spule und deren spezifische Eigenschaften bestimmt, beispielsweise in einer Referenzmessung gemessen, werden können, ist dann unabhängig davon, in welcher Magnetresonanzanlage die Spule verwendet wird, stets auf besonders einfache und schnelle Weise eine auf die individuelle Spule abgestimmte Frequenzgangkorrektur möglich. Die Frequenzgangdaten werden hier also in einem Bauteil gespeichert, welches flexibel an der Magnetresonanzanlage angebracht oder mit dieser verbunden und ebenso von dieser gelöst oder weggebracht werden kann. Dies stellt gegenüber herkömmlichen Lösungsansätzen einen signifikanten Fortschritt hinsichtlich einer Flexibilität und einer Aufwandsminimierung dar, da die Frequenzgangdaten nicht beispielsweise bei jedem Wechsel oder Austausch der Spule oder bei jeder Verwendung der Spule in einer neuen oder anderen Magnetresonanzanlage erneut gemessen werden müssen.

Vorteilhaft kann es vorgesehen sein, dass bei dem Verbinden der Spule mit der Magnetresonanzanlage automatisch überprüft wird, ob die jeweilige Spule einen entsprechenden Datenspeicher für die oder mit den Frequenzgangdaten aufweist. Ist dies der Fall wird der Datenspeicher zum Erfassen der Frequenzgangdaten automatisch ausgelesen. Eine Messung oder Bestimmung der Frequenzgangdaten der Spule oder eines die Spule umfassenden Subsystems wird dann automatisch nur dann ausgeführt, wenn die Spule keinen derartigen Datenspeicher aufweist, darin keine oder keine ausreichenden oder geeigneten Frequenzgangdaten gespeichert sind und/oder diese für die Frequenzgangkorrektur einen jeweiligen Anwendungsfall nicht ausreichen, beispielsweise nicht bei der tatsächlichen Messsequenz verwendete Frequenzen, Bandbreiten oder Magnetfeldstärken abdecken. Wird in einem solchen Fall eine Messung zum Bestimmen der Frequenzgangdaten durchgeführt, so können diese Frequenzgangdaten dann, gegebenenfalls zusätzlich oder ergänzend, automatisch auf dem Datenspeicher der Spule gespeichert werden, sodass sie für zukünftige Anwendungen zur Verfügung stehen.

Des Weiteren umfasst die Magnetresonanzanlage eine festverbaute Speichereinrichtung, in welcher die Frequenzgangdaten für wenigstens einen bestimmten Spulentyp abgelegt sind. Nach einem Verbinden der tauschbaren Spule mit der Magnetresonanzanlage wird dann anhand des Spulentyps automatisch überprüft, ob die abgelegten Frequenzgangdaten zu der verbundenen tauschbaren Spule passen. Es wird mit anderen Worten also ein Spulentyp der verbundenen tauschbaren Spule überprüft und ermittelt, ob für diesen Spulentyp Frequenzgangdaten in der Speichereinrichtung abgelegt oder hinterlegt sind. Ist dies der Fall, wird die Frequenzgangkorrektur auf Basis der in der Speichereinrichtung abgelegten Frequenzgangdaten durchgeführt. In diesem Fall ist es vorteilhaft also nicht notwendig, dass die Spule selbst über einen Datenspeicher mit spulenspezifischen Frequenzgangdaten verfügt. Dennoch wird so eine flexible Nutzbarkeit und Einsetzbarkeit von tauschbaren Spulen und ein gegenüber einer jeweiligen Neuvermessung der Frequenzgangdaten reduzierter Aufwand für die Frequenzgangkorrektur erreicht oder ermöglicht.

Weist die Spule hingegen einen eigenen Datenspeicher mit darin abgelegten spulenspezifischen Frequenzgangdaten auf, so können diese alternativ zu den in der Speichereinrichtung hinterlegten Frequenzgangdaten verwendet werden. Ebenso kann in einem solchen Fall eine Anpassung oder Fusion der jeweiligen Frequenzgangdaten aus der Speichereinrichtung und dem Datenspeicher, insbesondere automatisch, durchgeführt werden. Ebenso können anhand der jeweils anderen Frequenzgangdaten durch einen Vergleich eine Überprüfung und/oder eine Absicherung durchgeführt werden. Dadurch kann also besonders zuverlässig sichergestellt werden, dass die Frequenzgangkorrektur tatsächlich die Frequenzcharakteristik oder das Frequenzverhalten, also den Frequenzgang der jeweiligen tatsächlich verwendeten Spule korrigiert oder ausgleicht.

Die Verwendung von Spulen oder Spuleneinrichtungen mit integriertem Datenspeicher und darauf gespeicherten spulenspezifischen Frequenzgangdaten kann besonders vorteilhaft sein, wenn die Spulen oder deren Herstellung einer relativ großen Streuung oder Toleranz unterliegen, sodass sich zwei nominell oder spezifikationsgemäß gleiche Spulen, beispielsweise aus der gleichen Serienfertigung, hinsichtlich ihres Frequenzgangs dennoch messbar unterscheiden können. Demgegenüber können die in der Speichereinrichtung der Magnetresonanzanlage hinterlegten nur Spulentyp spezifischen Frequenzgangdaten vorteilhaft bei relativ kleiner Serienstreuung, also relativ kleiner Varianz mehrerer nominell oder spezifikationsgemäß gleicher Spulen verwendet werden, womit dann die einzelnen Spulen selbst weniger aufwendig und somit kostengünstiger gefertigt werden können. Zudem können, beispielsweise bei einer Modifikation der Magnetresonanzanlage entsprechende Anpassungen besonders einfach durch entsprechende Anpassung der in der Speichereinrichtung hinterlegten Frequenzgangdaten berücksichtigt werden.

In weiterer vorteilhafter Ausgestaltung der vorliegenden Erfindung ist in einer Datenverarbeitungseinrichtung der Magnetresonanzanlage ein vorgegebenes Modell für die Frequenzgangkorrektur hinterlegt. Die Frequenzgangdaten werden dann in Form von Parameterwerten für dieses Modell erfasst oder zum Erfassen bereitgestellt. Die Frequenzgangdaten können mit anderen Worten also in komprimierter Form in dem Datenspeicher hinterlegt sein, wodurch vorteilhaft Speicherplatz eingespart werden kann. Beispielsweise kann das vorgegebene Modell ein Polynom n-ten Grades sein oder umfassen. In dem Datenspeicher der Spule können dann der Grad n und/oder entsprechende spulenspezifische Koeffizienten für das Polynom als die Frequenzgangdaten gespeichert sein.

In weiterer vorteilhafter Ausgestaltung der vorliegenden Erfindung werden die Frequenzgangdaten in Kombination mit den Prescandaten aufgenommen, welche zur Normalisierung oder Korrektur einer räumlichen Empfindlichkeitsvariation aufgenommen werden. Mit anderen Worten werden die Frequenzgangdaten also durch eine Magnetresonanzmessung an oder mittels der Magnetresonanzanlage selbst gewonnen oder aus entsprechenden Messdaten abgeleitet. Dadurch kann vorteilhaft also eine separate Messung oder Bestimmung der Frequenzgangdaten entfallen, wodurch Zeit und Aufwand eingespart und das Verfahren vorteilhaft auf besonders einfache Weise automatisiert werden kann.

Konkret kann dazu der Prescan oder eine Prescanmessung, auch als Prescan-Normalize-Messung bezeichnet, angepasst werden. In einer vorteilhaften Weiterbildung der vorliegenden Erfindung wird demnach eine von der Messsequenz geforderte Bandbreite ermittelt und die Magnetresonanzanlage dann zum Aufnehmen der Prescandaten so eingestellt, dass sie sich dabei, also beim Aufnehmen der Prescandaten, zumindest im Wesentlichen die gleiche, insbesondere maximale, Bandbreite ergibt wie von der Messsequenz gefordert. Mit anderen Worten werden also der Prescan und die eigentliche Messsequenz, also das Aufnehmen der Magnetresonanz Daten für das Magnetresonanzbild, hinsichtlich der Bandbreite aneinander angepasst oder aufeinander abgestimmt. Der Frequenzgang für das Subsystem wird bei dem Aufnehmen der Prescandaten, also von Bildnormalisierungsdaten, mit aufgenommen, wobei die Prescanmessung so parametrisiert wird, dass sich dieselbe oder zumindest eine ähnliche Bandbreite ergibt, wie bei der letztendlichen klinischen Messung gemäß der vorgegebenen Messsequenz.

Dadurch wird der Frequenzgang des Subsystems bereits in der Prescanmessung berücksichtigt und ist entsprechend in dieser enthalten. Zum Einstellen oder Parametrisierung der Prescanmessung beziehungsweise der Magnetresonanzanlage zum Aufnehmen der Prescandaten kann beispielsweise eine Richtung und eine Größe oder Stärke eines Auslesegradienten (englisch: Readout Gradient) gemäß der Messsequenz eingestellt werden. Bei dem Prescan kann also die gleiche Frequenzkodierrichtung wie von der Messsequenz gefordert verwendet werden und es können dieselben Schichten des Untersuchungsobjekts angeregt werden. Um dennoch Zeit und Messaufwand einzusparen, kann der Prescan beispielsweise mit gegenüber dem Aufnehmen der Magnetresonanzdaten mittels der vorgegebenen Messsequenz reduzierter Auflösung durchgeführt werden. Ebenso kann für den Prescan eine andere, bevorzugt schnellere Sequenz als die vorgegebene Messsequenz verwendet werden. Dies beeinträchtigt die Frequenzgangkorrektur nicht, da aus den Prescandaten selbst kein Magnetresonanzbild rekonstruiert wird und somit beispielsweise ein bei der Prescanmessung erreichter Kontrastwert unerheblich ist.

Anhand der so aufgenommenen Prescandaten kann dann ein Gewichtungsfaktor zur Korrektur der räumlichen Empfindlichkeitsvariation und für die Frequenzgangkorrektur bestimmt werden. Dazu kann beispielsweise ein Verhältnis aus einer Empfindlichkeit oder eines Signals der Körperspule und der Empfindlichkeit oder eines Signals wenigstens einer Lokalspule gebildet werden. Der Korrektur- oder Gewichtungsfaktor kann dann auf die mittels der Messsequenz aufgenommenen Magnetresonanzdaten oder ein daraus erzeugtes vorläufiges Magnetresonanzbild appliziert oder angewendet werden und korrigiert dann nicht nur wie herkömmlich die räumliche Empfindlichkeitsvariation, sondern vorliegend auch den Frequenzgang. Dies ist bei heutzutage üblichen Verfahren nicht der Fall, da eine Abstimmung einer Frequenz und/oder Bandbreite zwischen dem Prescan und der klinischen Messung bisher nicht vorgesehen ist.

Sind zum Aufnehmen der Magnetresonanzdaten mehrere Messsequenzen vorgesehen und/oder weist die jeweilige Messsequenz mehrere Teilsequenzen auf, welche unterschiedliche Bandbreiten verwenden oder fordern, so können mehrere hinsichtlich der Bandbreite entsprechend angepasste Prescanmessungen durchgeführt, also mehrere Prescandatensätze aufgenommen werden. Dadurch kann die Frequenzgangkorrektur auch bei komplexen Messsequenzen besonders effizient und genau durchgeführt werden, da dann für die unterschiedlichen Bandbreiten oder Teilsequenzen hinsichtlich der Bandbreite entsprechend passende Prescandatensätze verfügbar sind.

In vorteilhafter Weiterbildung der vorliegenden Erfindung wird ein Bandbreitenschwellenwert vorgegeben und die Magnetresonanzanlage nur dann zum Erfassen der Frequenzgangdaten entsprechend der von der Messsequenz geforderten Bandbreite eingestellt, wenn diese geforderte Bandbreite den Bandbreitenschwellenwert erreicht oder überschreitet. Dadurch kann vorteilhaft berücksichtigt werden, dass nur dann, wenn die Bandbreite, insbesondere bei einem Niederfeldsystem, über dem Bandbreitenschwellenwert liegt, die Frequenzabhängigkeit, also eine Verstärkungs- oder Gainvariation über die Frequenz, so groß ist, dass in dem resultierenden Magnetresonanzbild signifikante Bildqualitätseinbußen zu befürchten sind. Auf diese Weise kann ohne nennenswerte Opferung von Bildqualität also vorteilhaft ein durchschnittlicher Aufwand zum Erzeugen des Magnetresonanzbildes des Untersuchungsobjekts reduziert werden, da die Frequenzgangkorrektur nicht bei jeder Messung tatsächlich notwendig ist, um eine ausreichende Bildqualität zu erreichen.

In vorteilhafter Weiterbildung der vorliegenden Erfindung werden mehrere Prescandatensätze mit unterschiedlichen Bandbreiten akquiriert. Die Frequenzgangdaten für die Frequenzgangkorrektur bei der von der Messsequenz tatsächlich verwendeten Bandbreite werden dann aus diesen mehreren Prescandatensätzen durch Interpolation bestimmt. Auf diese Weise kann beispielsweise Aufwand eingespart werden, wenn besonders viele Messsequenzen oder Teilsequenzen mit unterschiedlichen Bandbreiten verwendet werden sollen und/oder die Messsequenz nach dem Aufnehmen der Prescandaten nochmals verändert oder angepasst wird. Anstatt dann einen erneuten oder weiteren Prescan durchzuführen, können für die entsprechende Bandbreite geeignete Frequenzgangdaten durch das Interpolieren der mehreren Prescandatensätze hinsichtlich der Bandbreite simuliert werden. Dabei kann eine vorgegebene Abhängigkeit oder Funktion oder ein vorgegebenes Modell für die Interpolation verwendet werden, welches beispielsweise durch entsprechende Messreihen oder Versuche optimiert werden kann.

Zum Akquirieren der mehreren Prescandatensätze können mehrere Prescans nacheinander durchgeführt, also der Prescan mehrfach wiederholt mit verschiedenen Bandbreiten durchgeführt werden. Bevorzugt können die jeweiligen Prescandaten dabei jeweils bei der gleichen Echozeit TE gemessen werden, um besonders konsistente und miteinander kombinierbare Prescandatensätze zu erhalten. Ebenso können jedoch einige oder alle der mehreren Prescandatensätze nach einem einzigen Sende- oder TX-Pulses nacheinander, also zu unterschiedlichen Echozeiten TE gemessen werden, wobei jeweils zwischen zwei Messungen oder Echos die Bandbreite variiert werden kann, beispielsweise durch entsprechende Veränderung des Auslesegradienten. Da hierbei die mehreren Prescandatensätze zeitlich dichter beieinander liegend aufgenommen werden, ergibt sich so eine schnellere Messung oder Aufnahme der Prescandatensätze, welche zudem stabiler oder weniger anfällig gegenüber einer Bewegung des Untersuchungsobjekts ist. Unabhängig von der konkreten Ausführung gibt es bei dieser Ausgestaltung der vorliegenden Erfindung dann also mehrere Prescandatensätze mit verschiedenen oder für verschiedene Bandbreiten, die beispielsweise über eine gesamte Patientenmessung, also eine gesamte Untersuchungsdauer des Untersuchungsobjekts hinweg gespeichert und bei einem Rekonstruieren eines oder mehrerer Magnetresonanzbilder für die Frequenzgangkorrektur verwendet oder angewendet werden können. Dabei werden bei der Normalisierung eines klinischen Bildes, also eines Magnetresonanzbildes, die verschiedenen Prescandatensätze herangezogen und es wird zwischen diesen Prescandatensätzen entsprechend der Bandbreite interpoliert, sofern kein Prescandatensatz vorliegt, dessen Bandbreite genau derjenigen Bandbreite der jeweiligen Messsequenz oder Teilsequenz entspricht.

In einer alternativen vorteilhaften Ausgestaltung der vorliegenden Erfindung werden die Frequenzgangdaten separat von den Prescandaten aufgenommen, wobei anstelle eines vollständigen mit der Messsequenz oder dem Prescan abzubildenden Volumens nur eine gegenüber der Messsequenz beziehungsweise dem Prescan reduzierte Echoanzahl von wenigstens einem Echo, insbesondere höchstens 20 Echos, bevorzugt höchstens 10 Echos, gemessen wird. Dabei wird zumindest eine größte von der Messsequenz geforderte Bandbreite für das wenigstens eine Echo verwendet. Mit anderen Worten können die Frequenzgangdaten also durch ein entsprechendes MR-Experiment oder eine entsprechende MR-Messung aufgenommen oder ermittelt werden, um die genannten mehrfachen oder wiederholten Prescans zu vermeiden. Auch in diesem Fall können die Frequenzgangdaten auf die klinischen Bilddaten, also die Magnetresonanzdaten, und/oder die Prescandaten angewendet werden, um die durch den Frequenzgang erzeugte Bild Helligkeitsvariation zu korrigieren. Vorliegend wird dazu aber nicht das ganze 2D- oder 3D-Bildvolumen neu akquiriert oder vermessen, sondern lediglich nur genau ein Echo oder wenige Echos aufgenommen.

Die vorliegende Ausgestaltung der Erfindung beruht auf der Erkenntnis, dass die Information über den Frequenzgang bereits in einem einzigen Echo enthalten sein kann. Statt eines einzigen Echos kann ebenso beispielsweise eine einzige k-Raum Zeile aufgenommen werden. In jedem Fall wird durch das hier vorgeschlagene Verfahren eine Gesamtmesszeit nur unwesentlich verlängert aber dennoch eine signifikant verbesserte Bildqualität erreicht. Die tatsächlich durch die Messsequenz geforderte oder verwendeten Bandbreite B ist dabei gegeben durch B ~ G·FOV·γ gegeben, wobei G die Gradientenstärke, FoV das Sichtfeld (englisch: Field of View) und γ = 42,6 MHz/T das gyromagnetische Verhältnis des Protons angeben. Insbesondere sollte auch berücksichtigt werden, in welcher Richtung bei der Akquisition die größte Bandbreite auftritt.

Ähnlich wie im Zusammenhang mit den mehreren Prescandatensätzen beschrieben, können auch hier mehrere Echos hintereinander mit unterschiedlichen Bandbreiten jeweils von verschiedenen Pulsen, also bei verschiedenen Repetitionen, oder von einem einzigen Puls und dann bei verschiedenen Echozeiten TE gemessen werden. Ebenso kann gegebenenfalls analog zu der in Zusammenhang mit den mehreren Prescandatensätzen beschrieben eine entsprechende Interpolation der mit unterschiedlichen Bandbreiten aufgenommenen Echos durchgeführt werden, um eine exakte Frequenzgangkorrektur mit genau abgestimmter oder angepasster Bandbreite zu ermöglichen, wenn beispielsweise mehrere Messsequenzen oder Teilsequenzen mit unterschiedlichen Bandbreiten zum Aufnehmen der Magnetresonanzdaten verwendet werden sollen.

Das separate, also von dem Prescan unabhängige, Aufnehmen der Frequenzgangs Daten kann vorteilhaft eine verbesserte Flexibilität in der Anwendung des Verfahrens ermöglichen. So kann das Verfahren beispielsweise auch dann besonders Zeit sparen und für den jeweiligen Patienten besonders belastungsarm angewendet werden, wenn für die jeweilige Untersuchung kein herkömmlicher Prescan notwendig oder geplant ist. Durch die geringe Anzahl aufgenommener Echos können die Frequenzgangdaten zu dem zu unterschiedlichen Zeitpunkten der Gesamtuntersuchung oder Gesamtmessung, beispielsweise in einer ansonsten ungenutzten Messpause, gemessen werden, wodurch ein Untersuchungsablauf zeitlich gestrafft werden kann.

In vorteilhafter Weiterbildung der vorliegenden Erfindung wird wenigstens ein Referenzecho mit einer vorgegebenen ersten Bandbreite aufgenommen, welche so klein ist, dass höchsten vernachlässigbar geringe Frequenzabhängigkeitseffekte auftreten, wobei das Referenzecho und das Echo mit der größten Bandbreite denselben Bildinhalt abbilden. Die Frequenzgangdaten werden dann durch Vergleich dieser beiden Echos miteinander bestimmt. Beispielsweise kann unter der Annahme, dass das Referenzecho mit der relativ kleinen Bandbreite keine oder kaum eine Frequenzabhängigkeit zeigt und der Annahme, dass das Echo mit der größeren Bandbreite denselben Bildinhalt abbildet, aus dem Vergleich beider Echos auf den Frequenzgang zurück geschlossen werden. Dazu können insbesondere jeweilige Frequenzachsen zunächst aufeinander abgebildet und dann in der Frequenzdomäne ein Verhältnis der beiden Echos gebildet werden. Der so bestimmte Frequenzgang beziehungsweise ein so bestimmter Korrekturfaktor für die Frequenzgangkorrektur kann dann auf die Magnetresonanzdaten oder ein daraus erzeugtes vorläufiges Magnetresonanzbild oder auf die Prescandaten angewendet werden, welche dann wiederum auf die Magnetresonanzdaten oder das vorläufige Magnetresonanzbild angewendet werden kann, um ebenfalls die Frequenzgangkorrektur zu erreichen. Das hier beschriebene Vorgehen stellt eine besonders einfache Möglichkeit dar, die Frequenzgangkorrektur allein auf Basis von mittels der Magnetresonanzanlage selbst Aufnehmen war der Daten zu realisieren.

In weiterer vorteilhafter Ausgestaltung der vorliegenden Erfindung werden zum Bestimmen der Frequenzgangdaten für eine Lokalspule eines Empfangssystems der Magnetresonanzanlage frequenzabhängige Signaldaten sowohl für die Lokalspule als auch für eine Körperspule eines Sendersystems der Magnetresonanzanlage gemessen, wobei die Lokalspule breitbandiger ist als die Körperspule. Es werden dann durch Vergleich der Signaldaten miteinander die Frequenzgangdaten für die Lokalspule bestimmt, welche dann - zumindest im Wesentlichen - frei von einem Einfluss eines Frequenzgangs der Körperspule sind. Hier kann also das im Zusammenhang mit den mehreren Echos unterschiedlicher Bandbreite beschriebene Prinzip auf die Verwendung der Lokalspule und der Körperspule übertragen werden. Wenn man ausschließlich den Frequenzgang des Empfangssystems beziehungsweise der Lokalspule aufnehmen oder bestimmen möchte, der im Idealfall frei vom Frequenzgangs der Körperspule, also des Sendersystems, ist, müssen also bei Verwendung des vorliegenden Verfahren vorteilhaft nicht Lokalspulen und Körperspulen mit der gleichen Bandbreite verwendet werden. Dadurch ist die vorliegende Erfindung besonders flexibel, also in besonders vielen Situationen oder Einzelfällen für die Frequenzgangkorrektur anwendbar.

Hintergrund ist hier, dass bei einem Prescan zur Normalisierung aufgenommene frequenzabhängige Signaldaten oder Verstärkungsdaten beziehungsweise ein entsprechendes Verhältnis G_{LC}(x,y,z,f)/G_{BC}(x,y,z,f) der orts- und frequenzabhängigen Signalverstärkungen G_{LC} der Lokalspule und G_{BC} der Körperspule auch immer den Frequenzgang der Körperspule enthalten, der in einem empfangsseitigen Profil, also einem Profil des Empfangssystems, nicht enthalten ist. Zudem nutzen die gesendeten Signale oder Pulse in der klinischen Sequenz, also der Messsequenz zum Aufnehmen der Magnetresonanzdaten für das Magnetresonanzbild, typischerweise andere Bandbreiten als das Empfangssystem.

Um diesem Problem zu begegnen wird hier vorgeschlagen, dass eine Lokalspule und eine Körperspule mit verschiedenen Bandbreiten verwendet beziehungsweise entsprechende Signaldaten mit verschiedenen Bandbreiten akquiriert werden und aus dem Vergleich dieser Signaldaten ein Frequenzgang abgeleitet wird, der - zumindest weitestgehend - frei von dem Frequenzgang der Körperspule ist: G_{LC}(x,y,z,f)/G_{BC}(x,y,z). Dazu können wie beschrieben die mit der kleineren Bandbreite aufgenommenen Signaldaten auf die Frequenzachse oder Bandbreite der mit der größeren Bandbreite aufgenommenen Signaldaten abgebildet, also entsprechend gestreckt, gedehnt oder expandiert werden, wodurch die Frequenzabhängigkeit effektiv vermieden oder eliminiert werden kann.

In weiterer vorteilhafter Ausgestaltung der vorliegenden Erfindung wird auf einer Senderseite der Magnetresonanzanlage ein bei der Messsequenz auf eine Sendespule, beispielsweise die genannte Körperspule, gegebenes Signal in Abhängigkeit von den Frequenzgangdaten verzerrt und dadurch eine Frequenzabhängigkeit, also der Frequenzgang, eines Ausgangssignals der Sendespule und/oder eines korrespondierenden mittels einer Empfangsspule der Magnetresonanzanlage gemessenen Signals ausgeglichen. Mit anderen Worten wird das auf die Sendespule gegebenes Signal also frequenzabhängig verzerrt, um der unerwünschten Frequenzabhängigkeit, also dem nicht-flachen Frequenzgang der Sendespule und/oder der Empfangsspule entgegenzuwirken. Auf diese Weise kann vorteilhaft ermöglicht werden, dass die dann unter Verwendung der Messsequenz aufgenommenen Magnetresonanzdaten bereits Frequenzgang korrigiert aufgenommen werden. Dadurch können diese Magnetresonanzdaten dann besonders flexibel, beispielsweise mit beliebigen herkömmlichen Datenverarbeitungseinrichtungen zur Bildrekonstruktion, zum Rekonstruieren oder Erzeugen des Magnetresonanzbildes weiterverarbeitet werden, ohne dass dabei besondere oder weitere Maßnahmen oder Schritte notwendig wären, um eine verbesserte Bildqualität zu erreichen.

Ein weiterer Aspekt der vorliegenden Erfindung ist ein computerlesbares Speichermedium, insbesondere für eine Magnetresonanzanlage, auf dem ein Computerprogramm oder Computerprogrammprodukt, also ein Programmcode, gespeichert ist, welches beziehungsweise welcher Befehle oder Steueranweisungen umfasst oder kodiert, die bei einer Ausführung des Computerprogramms oder Programmcodes durch eine Datenverarbeitungseinrichtung, insbesondere eine oder einer Magnetresonanzanlage, diese dazu veranlassen, zumindest eine Ausführungsform des erfindungsgemäßen Verfahrens, insbesondere automatisch oder teilautomatisch, auszuführen. Das erfindungsgemäße Verfahren kann also in Form des Computerprogramms ein computerimplementiertes Verfahren sein. Ein solches Computerprogramm stellt für sich einen weiteren Aspekt der vorliegenden Erfindung dar.

Ein weiterer Aspekt der vorliegenden Erfindung ist eine Magnetresonanzanlage, welche ein computerlesbares Speichermedium aufweist. Mit anderen Worten ist die erfindungsgemäße Magnetresonanzanlage also zum, insbesondere automatischen oder teilautomatischen, Ausführen zumindest einer Ausführungsform oder Variante des erfindungsgemäßen Verfahrens ausgebildet und eingerichtet. Dementsprechend kann die im Zusammenhang mit dem erfindungsgemäßen Verfahren und/oder im Zusammenhang mit dem erfindungsgemäßen computerlesbaren Speichermedium genannten Magnetresonanzanlage insbesondere die erfindungsgemäße Magnetresonanzanlage sein. Die erfindungsgemäße Magnetresonanzanlage kann also einzelne, einige oder alle der im Zusammenhang mit dem erfindungsgemäßen Verfahren oder dem erfindungsgemäßen computerlesbaren Speichermedium genannten Eigenschaften und/oder Bauteile oder Komponenten aufweisen.

Die bisher und im Folgenden angegebenen Eigenschaften und Weiterbildungen des erfindungsgemäßen Verfahrens, des erfindungsgemäßen Verfahrens, des erfindungsgemäßen computerlesbaren Speichermediums, und der erfindungsgemäßen Magnetresonanzanlage sowie gegebenenfalls weiterer Aspekte der vorliegenden Erfindung sind wechselseitig zwischen diesen Aspekten der vorliegenden Erfindung übertragbar. Es gehören also zu der Erfindung auch solche Weiterbildungen des erfindungsgemäßen Verfahrens, des erfindungsgemäßen Speichermediums und der erfindungsgemäßen Magnetresonanzanlage, welche Ausgestaltungen aufweisen, die hier zur Vermeidung unnötiger Redundanz nicht explizit in der jeweiligen Kombination oder nicht für jeden dieser Aspekte der vorliegenden Erfindung separat beschrieben sind, aber unter den Schutzumfang der Ansprüche fallen.

Weitere Merkmale, Einzelheiten und Vorteile der vorliegenden Erfindung ergeben sich aus der nachfolgenden Beschreibung bevorzugter Ausführungsbeispiele sowie anhand der Zeichnungen. Dabei zeigen:
- FIG 1: eine schematische Ansicht einer Magnetresonanzanlage;
- FIG 2: einen ersten schematischen Ablaufplan zum Illustrieren eines Verfahrens zum Erzeugen eines Magnetresonanzbildes mit verbesserter Bildqualität;
- FIG 3: einen zweiten schematischen Ablaufplan zum Illustrieren eines Verfahrens zum Erzeugen eines Magnetresonanzbildes mit verbesserter Bildqualität;
- FIG 4: eine schematische diagrammatische Darstellung eines MR-Echosignals eines Untersuchungsobjekts;
- FIG 5: eine schematische diagrammatische Darstellung einer Frequenzantwort eines Empfangssystems einer Magnetresonanzanlage;
- FIG 6: eine schematische diagrammatische Darstellung eines als Produkt des MR-Echosignals aus FIG 4 und der Frequenzantwort aus FIG 5 gemessenen MR-Signals;
- FIG 7: eine schematische diagrammatische Darstellung eines schmalbandig aufgenommenen MR-Echosignals eines Untersuchungsobjekts;
- FIG 8: eine schematische diagrammatische Darstellung des auf eine größere Bandbreite expandierten MREchosignals aus FIG 7;
- FIG 9: eine schematische diagrammatische Darstellung eines breitbandig gemessenen MR-Echosignals eines Untersuchungsobjekts;
- FIG 10: eine erste schematische Übersichtsdarstellung zum Illustrieren einer Realisierungsmöglichkeit eines Verfahrens zum Erzeugen eines Magnetresonanzbildes mit verbesserter Bildqualität; und
- FIG 11: eine zweite schematische Übersichtsdarstellung zum Illustrieren einer Realisierungsmöglichkeit eines Verfahrens zum Erzeugen eines Magnetresonanzbildes mit verbesserter Bildqualität.

Bei den im Folgenden erläuterten Ausführungsbeispielen handelt es sich um bevorzugte Ausführungsformen der Erfindung. Bei den Ausführungsbeispielen stellen die beschriebenen Komponenten der Ausführungsformen jeweils einzelne, unabhängig voneinander zu betrachtende Merkmale der Erfindung dar, welche die Erfindung jeweils auch unabhängig voneinander weiterbilden und damit auch einzeln oder in einer anderen als der gezeigten Kombination als Bestandteil der Erfindung anzusehen sind, sofern dies unter den Schutzumfang der Ansprüche fällt. Des Weiteren sind die beschriebenen Ausführungsformen auch durch weitere der bereits beschriebenen Merkmale der Erfindung ergänzbar.

In den Figuren sind gleiche, funktionsgleiche oder einander entsprechende Elemente jeweils mit den gleichen Bezugszeichen gekennzeichnet.

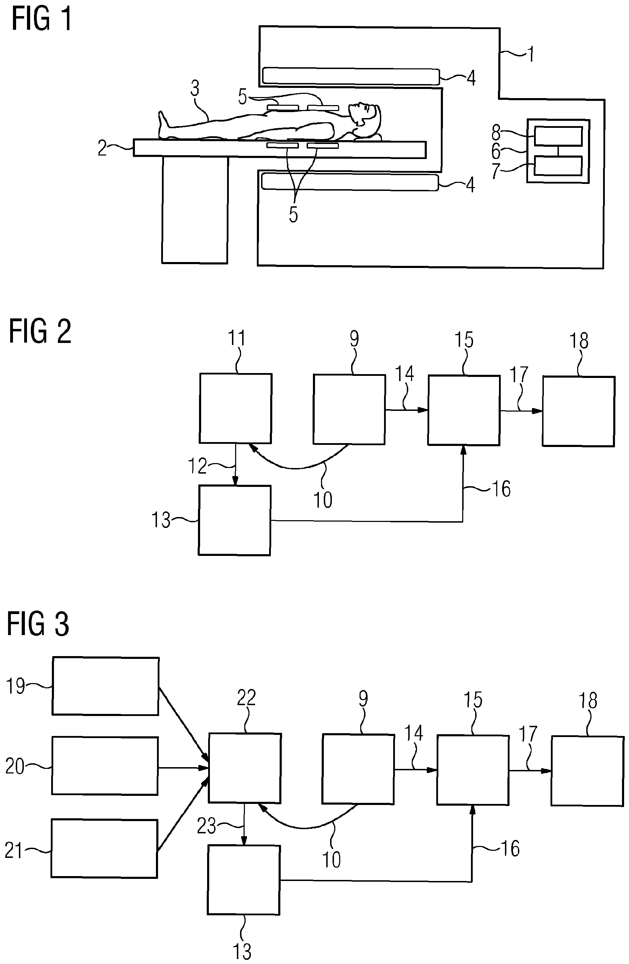

FIG 1 zeigt eine schematische Ansicht einer Magnetresonanzanlage, welche hier kurz als MR-Anlage 1 bezeichnet wird. Die MR-Anlage 1 weist einen Patiententisch 2 auf, auf dem vorliegend ein zu untersuchender oder abzubildender Patient 3 liegt. Darüber hinaus weist die MR-Anlage 1 zum Abbilden oder Untersuchen des Patienten 3 ein Sendesystem, vorliegend schematisch repräsentiert durch eine Körperspule 4, und ein Empfangssystem, vorliegend schematisch repräsentiert durch an dem Patienten 3 angeordnete Lokalspulen 5, auf. Weiter umfasst die MR-Anlage 1 eine Datenverarbeitungseinrichtung 6, welche ihrerseits ein Speichermedium 7 und einen damit verbundenen Prozessor 8 umfasst. Die Datenverarbeitungseinrichtung 6 kann ebenfalls Teil des Sendesystems und/oder Empfangssystems sein. Die MR-Anlage 1 ist vorliegend eingerichtet zum Durchführen eines Verfahrens zum Abbilden des Patienten 3 und zum Erzeugen eines Magnetresonanzbildes mit gegenüber herkömmlichen Magnetresonanzbildern verbesserter Bildqualität. Dazu ist auf dem Speichermedium 7 ein entsprechendes Steuer- oder Computerprogramm gespeichert, welches mittels des Prozessors 8 ausführbar ist, um die MR-Anlage 1 beziehungsweise die Datenverarbeitungseinrichtung 6 entsprechend zu steuern.

Details und Varianten dieses Verfahrens werden im Folgenden unter Bezugnahme auf die FIG 1 und die übrigen Figuren näher erläutert.

FIG 2 zeigt schematisch einen ersten Ablaufplan zum Illustrieren des Verfahrens zum Erzeugen des Magnetresonanzbildes. Dabei wird zunächst eine Messsequenz 9 definiert und vorgegeben, mittels welcher Magnetresonanz- oder MR-Daten des Patienten 3 im Rahmen einer klinischen Messung mittels der MR-Anlage 1 aufgenommen werden sollen. In einem Verfahrensschritt 10 werden aus dieser Messsequenz 9 Frequenzinformationen bestimmt oder abgeleitet, welche insbesondere eine durch die Messsequenz 9 geforderte Bandbreite und gegebenenfalls auch eine Gradientenorientierung umfassen. Gemäß diesen Frequenzinformationen wird dann ein Prescan 11, also ein vor der Messsequenz 9 durchzuführender Vorabscan, konfiguriert, sodass bei dem Prescan 11 beispielsweise zumindest im Wesentlichen die gleiche Bandbreite, die gleiche Frequenzkodierrichtung und Gradientenorientierung verwendet wird wie in der Messsequenz 9.

In einem Verfahrensschritt 12 wird dieser so konfigurierte Prescan 11 dann durchgeführt, wodurch im Ergebnis Prescandaten 13 erhalten werden. Die Prescandaten 13 enthalten Daten bezüglich einer räumlichen Empfindlichkeitsvariation der räumlich verteilt angeordneten Lokalspulen 5 sowie - aufgrund der in Abhängigkeit von der Messsequenz 9 durchgeführten Konfiguration - Frequenzgangdaten, welche eine Frequenzabhängigkeit oder ein Frequenzverhalten oder eine Frequenzcharakteristik der Lokalspulen 5 und optional der Körperspule 4 angeben.

In einem Verfahrensschritt 14 wird die vorgegebene Messsequenz 9 zum Abbilden des Patienten 3 ausgeführt, wodurch sich im Ergebnis entsprechende Magnetresonanzdaten oder ein vorläufiges MR-Bild 15 ergeben. In einem Verfahrensschritt 16 werden die Prescandaten 13 auf die Magnetresonanzdaten beziehungsweise in einem Verfahrensschritt 17 auf das vorläufige MR-Bild 15 angewendet, um durch die räumliche Empfindlichkeitsvariation sowie die Frequenzabhängigkeit oder den Frequenzgang verursachte Effekte oder Störungen zu korrigieren. Diese Effekte oder Störungen können sich in dem vorläufigen MR-Bild 15 niederschlagen, repräsentieren jedoch keine tatsächlichen Eigenschaften des Patienten 5 und sind daher irreführend und unerwünscht.

Beispielsweise kann aus den Prescandaten 13 ein entsprechender Korrekturfaktor bestimmt werden, welcher dann in dem Verfahrensschritt 17 auf das vorläufige MR-Bild 15 zu dessen Korrektur angewendet, beispielsweise pixelweise mit diesem multipliziert wird. Daraus resultiert ein finales oder endgültiges korrigiertes MR-Bild 18, welches aufgrund der Korrektur eine gegenüber dem vorläufigen MR-Bild 15 verbesserte Bildqualität aufweist.

FIG 3 zeigt einen zweiten schematischen Ablaufplan zum Illustrieren einer Variante des Verfahrens. Aufgrund einer teilweisen Gleichheit dieser Variante des Verfahrens mit der in FIG 2 illustrierten Variante, wird hier lediglich auf die Unterschiede eingegangen. So ist es hier vorgesehen, dass zunächst mehrere Prescan mit unterschiedlichen Bandbreiten konfiguriert werden, beispielsweise ein erster Prescan 19 mit einer relativ niedrigen ersten Bandbreite, ein zweiter Prescan 20 mit einer größeren zweiten Bandbreite und ein dritter Prescan 21 mit einer noch größeren dritten Bandbreite. Eine entsprechende Prescankonfiguration 22 kann in Abhängigkeit von der Messsequenz 9 beziehungsweise den daraus bestimmten Frequenzinformationen vorgegeben oder vorgenommen werden. Dadurch kann beispielsweise sichergestellt werden, dass von den mehreren Prescans 19, 20, 21 zumindest einer eine größte von der Messsequenz geforderte Bandbreite abdeckt. Ebenso kann die Prescankonfiguration 22 aber unabhängig von der Messsequenz 9 vorgegeben oder vorgenommen werden, wodurch beispielsweise ein entsprechender Anpassungs- oder Abstimmungsaufwand eingespart werden kann.

Es kann dann überprüft werden, ob die von der Messsequenz 9 geforderte Bandbreite der Bandbreite eines der Prescan 19, 20, 21 entspricht. Ist dies der Fall, kann in einem Verfahrensschritt 23 der entsprechende Prescan 19, 20, 21 durchgeführt werden. Ist dies hingegen nicht der Fall, so können in dem Verfahrensschritt 23 mehrere oder alle der Prescans 19, 20, 21 durchgeführt werden. Entsprechende Messwerte werden dann gemäß der Bandbreite interpoliert, um Prescandaten 13 für die von der Messsequenz 9 geforderte Bandbreite zu erhalten. Anschließend wird das Verfahren wie beschrieben weitergeführt, um das korrigierte MR-Bild 18 zu erzeugen.

Bei den in FIG 2 und FIG 3 illustrierten Varianten werden also Frequenzgangdaten zum Korrigieren oder Ausgleichen der Frequenzabhängigkeit oder des Frequenzverhaltens der Empfangssysteme, welche eine Lokalspule umfassen, und optional der Sendesysteme der MR-Anlage 1 in Kombination mit dem Prescan 11 beziehungsweise 19, 20, 21 erfasst.

Ebenso können entsprechende Frequenzgangdaten aber beispielsweise unabhängig von dem Prescan 11, 19, 20, 21 aufgenommen oder bestimmt werden, etwa mittels eines separaten MR-Experiments oder einer separaten MR-Messung mittels der MRT Anlage 1.

Die folgenden Ausführungen befassen sich zwar beispielhaft mit der Frequenzabhängigkeit einer Amplitude A, da eine amplituden-gewichtete Bildgebung die am weitesten verbreitete MR-Anwendung ist, können sich aber ebenso auf eine Frequenzabhängigkeit jeweiliger Phasen entsprechender Signale beziehen.

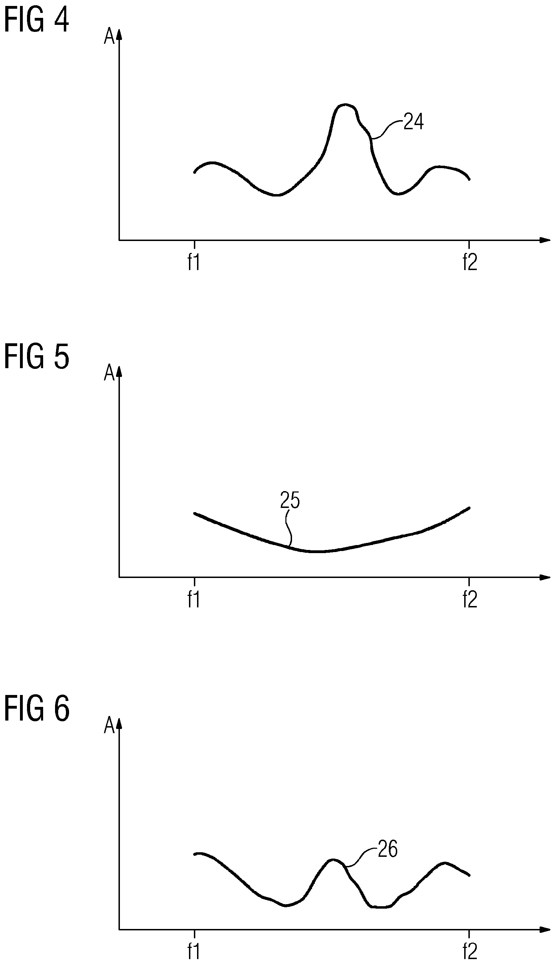

FIG 4 zeigt hierzu schematisch ein Diagramm, auf dessen x-Achse eine Frequenz 11 und auf dessen γ-Achse eine Amplitude A aufgetragen sind. In dem Diagramm ist beispielhaft und schematisch ein Objektsignal 24 dargestellt. Das Objektsignal 24 illustriert einen Anteil eines mittels der Lokalspulen 5 gemessenen MR-Signals, welcher tatsächliche Eigenschaften des Patienten 3 repräsentiert, wobei angenommen wird, dass die Einrichtungen der MR-Anlage 1 keinen beziehungsweise einen flachen Frequenzgang aufweisen, das heißt also gleich starke Signale unterschiedlicher Frequenzen f unabhängig von deren Frequenz f mit der gleichen Stärke oder Amplitude A messen beziehungsweise aussenden. Das Objektsignal 24 stellt also ein theoretisches Idealsignal dar, welches für diagnostische Zwecke eigentlich von Interesse ist. In der Realität ist jedoch zu beobachten, dass die Einrichtungen oder Systeme der MR-Anlage 1 einen nicht-flachen Frequenzgang aufweisen, also gesendete beziehungsweise gemessene Signale durch ihre eigenen Eigenschaften beeinflussen oder überlagern. FIG 5 zeigt hierzu, ebenfalls in einem schematischen Frequenz-Amplituden-Diagramm, eine Frequenzantwort 25 der Lokalspulen 5. Insbesondere ist die Frequenzantwort 25 nicht flach, sodass beim Messen von MR-Signalen mittels der Lokalspulen 5 dieser Frequenzgang 25 den durch den Patienten 5 verursachten oder den Patienten 5 repräsentierenden Signalanteilen überlagert wird.

Tatsächlich gemessen wird also eine Überlagerung oder Multiplikation des Objektssignals 24 und der Frequenzantwort 25, was in FIG 6, ebenfalls in einem Frequenz-Amplituden-Diagramm, schematisch als Messsignal 26 dargestellt ist. Anschaulich kann also das Messsignal 26 durch die Frequenzantwort 25 geteilt werden, um das um den Frequenzgang der Lokalspulen 5 korrigierte oder bereinigte Objektsignal 24 zu erhalten, aus welchem dann das im Vergleich zur Verwendung des Messsignals 26 in seiner Bildqualität verbesserte MR-Bild 18 generiert werden kann.

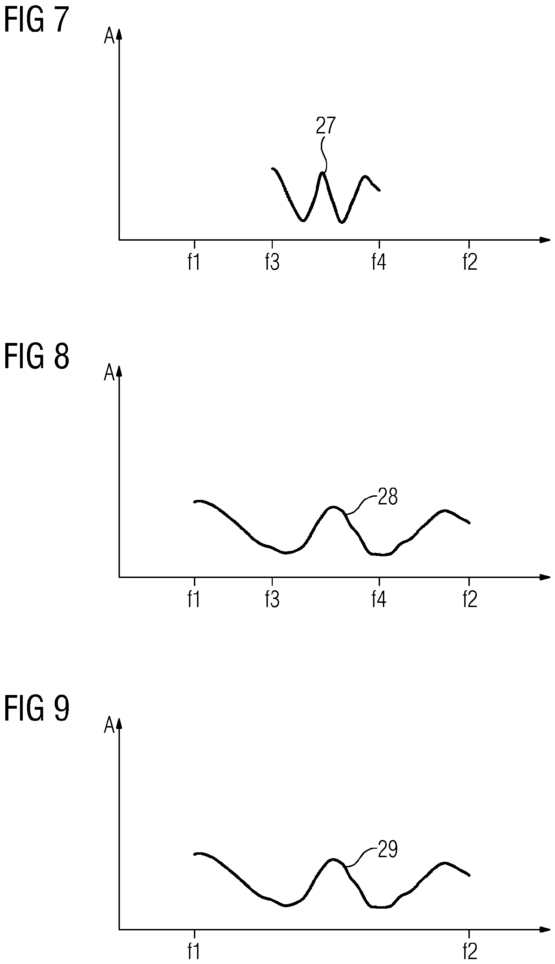

FIG 7 bis FIG 9 zeigen jeweilige schematische Frequenz-Amplituden-Diagramme anhand welcher erläutert wird, wie ein Frequenzgang beispielsweise der Lokalspulen 5, also beispielsweise die Frequenzantwort 25, aus Messungen mittels der MR-Anlage 1 bestimmt werden kann. Dazu zeigt FIG 7 schematisch ein Schmalbandsignal 27, welches ein schmalbandig mit einer Bandbreite f4-f3 aufgenommenes MR-Signal des Patienten 3 darstellt. Die Bandbreite f4-f3 ist dabei so gering, dass auch dann, wenn es sich bei der MR-Anlage 1 um ein Niederfeldsystem handelt, kein nennenswerter oder signifikanter Einfluss der Frequenzabhängigkeit anzunehmen ist. Für das Schmalbandsignal 27 kann also ein flacher Frequenzgang angenommen werden. Das Schmalbandsignal 27 wird dann rechnerisch auf die größere volle Bandbreite f2-f1 expandiert oder gestreckt. Dies ergibt ein schematisch in FIG 8 dargestelltes expandiertes Signal 28, welches zwar die volle Bandbreite f2-f1, welche beispielsweise durch die Messsequenz 9 gefordert wird, abdeckt, dabei jedoch frei von dem Frequenzgang ist, da es aus dem Schmalbandsignal 27 resultiert. Zusätzlich wird ein schematisch in FIG 9 dargestelltes Breitbandsignal 29 des Patienten 3 mit der vollen Bandbreite f2-f1 aufgenommen. Es kann dann ein Quotient aus dem Breitbandsignal 29 und dem expandierten Signal 28 gebildet werden, um den Frequenzgang, also beispielsweise die Frequenzantwort 25, ohne tatsächlichen den Patienten 3 repräsentierenden Bildinhalt zu erhalten.

In den beschriebenen Arten und Weisen kann also der Frequenzgang, insbesondere des Empfangssystems, also der Lokalspulen 5, der MR-Anlage 1, mittels der MR-Anlage 1 selbst bestimmt oder abgeleitet werden, zum Beispiel durch Anpassung oder Erweiterung heutzutage bekannter Prescan-Normalize-Messungen und durch Eliminierung des Frequenzgangs der Einrichtungen des Sende- und/oder Empfangssystems der MR-Anlage 1.

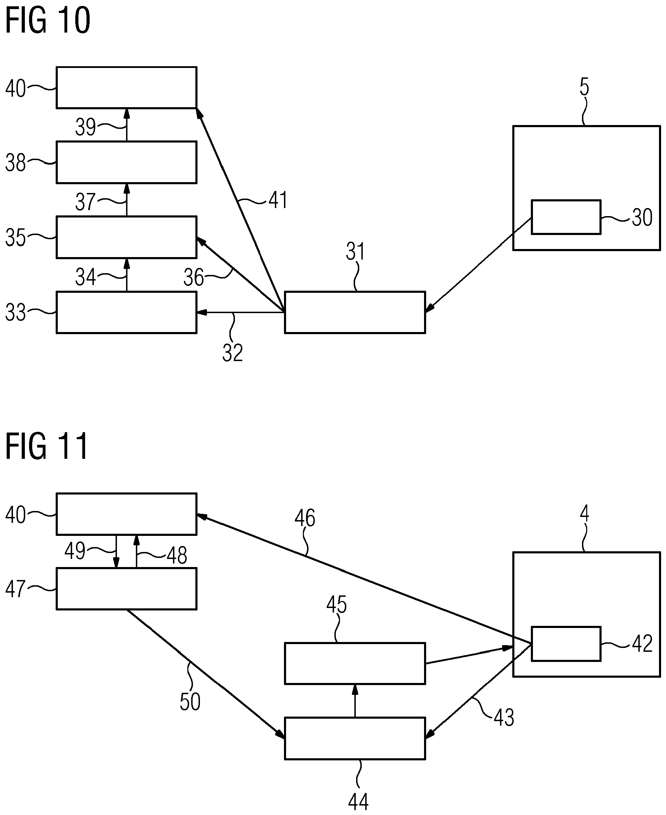

FIG 10 zeigt eine erste schematische Übersichtsdarstellung zum Illustrieren einer weiteren Realisierungsmöglichkeit des Verfahrens zum Erzeugen dem des MR-Bildes 18 mit verbesserter Bildqualität. Spezifisch sind hier verschiedene Varianten eines Datenflusses und einer Datenverarbeitung in dem Empfangssystem der MR-Anlage 1 illustriert. Vorliegend ist es dabei vorgesehen, dass die Lokalspulen 5 einen jeweiligen Datenspeicher 30 umfassen, in welchem Frequenzgangdaten der jeweiligen Lokalspule 5 abgelegt sind. Der jeweilige Datenspeicher 30 kann über eine kabelgebundene oder kabellose Datenverbindung von einer Empfangssteuereinrichtung 31 (englisch: RX Controller) ausgelesen werden. Die Empfangssteuereinrichtung 31 kann die Frequenzgangdaten dann über einen Datenpfad 32 an einen Analogempfänger 33 weitergeben. Der Analogempfänger 33 kann beispielsweise ein dedizierter des FPGA aufweisen, welches zum automatischen Durchführen eines Frequenz-Equalizings, also der Frequenzgangkorrektur auf Basis der Frequenzgangdaten, eingerichtet ist.

Zusätzlich oder alternativ kann der Analogempfänger 33 die Frequenzgangdaten über einen Datenpfad 34 an einen Digitalempfänger 35 weitergeben. Alternativ kann die Empfangssteuereinrichtung 31 die Frequenzgangdaten über einen Datenpfad 36 direkt an den Digitalempfänger 35 übermitteln. Der Digitalempfänger 35 kann wie der Analogempfänger 33 ein für die Frequenzgangkorrektur eingerichtetes FPGA aufweisen und damit die Frequenzgangkorrektur auf Basis der Frequenzgangdaten automatisch durchführen.

Ebenso kann der Digitalempfänger 35 die Frequenzgangdaten über einen Datenpfad 37 an ein Steuergerät 38 weitergeben, welches die Frequenzgangdaten wiederum über einen Datenpfad 39 an einen Bildrekonstruktionscomputer 40 weitergeben kann. Ebenso kann die Empfangssteuereinrichtung 31 die Frequenzgangdaten über einen Datenpfad 41 direkt an den Bildrekonstruktionscomputer 40 übermitteln. Auf dem Bildrekonstruktionscomputer 40 kann eine Betriebssoftware, also ein Computerprogramm ausgeführt werden, welches auf Basis der Frequenzgangdaten ein Software-Frequenz-Equalizing durchführt, die Frequenzabhängigkeit, also den Frequenzgang der Lokalspulen 5, also in Software automatisch korrigiert oder ausgleicht.

Zumindest der Bildrekonstruktionscomputer 40 kann beispielsweise Teil der Datenverarbeitungseinrichtung 6 sein. Die Komponenten 31, 33, 35, 38 können ebenfalls Teil der Datenverarbeitungseinrichtung 6 oder mit dieser verbunden als Teil der MR-Anlage 1 vorgesehen sein.

FIG 11 zeigt eine zweite schematische Übersichtsdarstellung zum Illustrieren einer Realisierungsmöglichkeit des Verfahrens zum Erzeugen des MR-Bild des 18 mit verbesserter Bildqualität. Spezifisch sind hier mögliche Varianten eines Datenflusses und einer Datenverarbeitung in dem Sendesystem der MR-Anlage 1 illustriert. Vorliegend weist die Körperspule 4 dabei einen Datenspeicher 42 auf, in welchem Frequenzgangdaten der Körperspule 4 hinterlegt sind. Diese Frequenzgangdaten der Körperspule 4 können über einen Datenpfad 43 an eine Sendesteuereinrichtung 44 übermittelt werden. Die Sendesteuereinrichtung 44 kann beispielsweise ein dedizierter des FPGA zum automatischen Ausführen einer Verzerrung oder vor Verzerrung eines gesendeten oder zu sendenden Signals oder Pulses aufweisen.

Die Sendesteuereinrichtung 44 kann also ein in Abhängigkeit von den Frequenzgangdaten der Körperspule 4 zum Ausgleichen oder Glätten von deren Frequenzgang verzerrtes, also modifiziertes, Signal oder entsprechende Steueranweisungen für eine Verzerrung beziehungsweise eine Erzeugung eines entsprechend verzerrten Signals erzeugen und an einen Verstärker 45 (RFPA, englisch: Radio-Frequency Power Amplifier) übermitteln. Der Verstärker 45 wiederum kann das entsprechend verzerrte Signal auf die Körperspule 4 geben.

Zusätzlich oder alternativ können die in dem Datenspeicher 42 hinterlegten Frequenzgangdaten über eine Datenverbindung oder einen Datenpfad 46 an ein senderseitiges Steuergerät 47 (englisch: TX Controller) übermittelt beziehungsweise durch dieses ausgelesen werden. Das senderseitige Steuergerät 47 kann die Frequenzgangdaten über einen Datenpfad 48 an den Bildrekonstruktionscomputer 40 weitergeben, welcher eine Software-Vorverzerrung durchführen kann, also eine entsprechende Verzerrung oder entsprechende Steueranweisungen für eine Verzerrung des mittels des HF-Verstärkers 45 auf die Körperspule 4 zu gebenden Signals zum Ausgleichen von deren Frequenzgang in Software berechnen kann. Anschließend kann der Bildrekonstruktionscomputer 40 über einen Datenpfad 49 die berechnete Verzerrung oder entsprechende Steueranweisungen zurück an das senderseitiges Steuergerät 47 übermitteln, welches sie wiederum über einen Datenpfad 50 an die Sendesteuereinrichtung 44 übermitteln kann, welche letztendlich den Verstärker 45 entsprechend ansteuert.

Die hier beschriebenen und illustrierten Verarbeitungsarchitekturen stellen vorteilhafte Realisierungsmöglichkeit zum Korrigieren, Normalisieren oder Ausgleichen der unerwünschten Frequenzabhängigkeit der Hardwareeinrichtungen oder Systeme der MR-Anlage 1 dar.

Insgesamt zeigen die beschriebenen Beispiele, wie eine Frequenzgangkorrektur durch Integration eines Frequenz-Equalizings in die Prescan-Normalize-Messung und/oder durch ein Normalizing auf Basis von in wenigstens einer Komponente oder einem Subsystem, insbesondere einer von der MR-Anlage 1 abdockbaren Komponente wie etwa den Lokalspulen 5, abgespeicherten Frequenzgangdaten durchgeführt und realisiert werden kann, um eine verbesserte Bildqualität des resultierenden MR-Bildes 18 zu erreichen.

## Patentansprüche

1. Verfahren zum Verbessern einer Bildqualität eines Magnetresonanzbildes (18), bei dem
- Magnetresonanzdaten eines Untersuchungsobjekts (3) erfasst werden, welche mittels einer Magnetresonanzanlage (1) gemäß einer vorgegebenen Messsequenz (9) aufgenommen wurden, und welche zur Rekonstruktion des Magnetresonanzbildes (18) dienen,
- separat von der Messsequenz (9) Frequenzgangdaten (25) für ein Subsystem (4, 5) der Magnetresonanzanlage (1) erfasst werden,
- anhand der Frequenzgangdaten (25) eine Frequenzgangkorrektur für die Magnetresonanzdaten oder von Prescandaten (13) durchgeführt wird,
wobei die Prescandaten (13) bei der Rekonstruktion des Magnetresonanzbildes (18) aus den Magnetresonanzdaten berücksichtigt werden, **dadurch gekennzeichnet, dass** das Subsystem (4, 5) eine tauschbare Spule (5), insbesondere eine Lokalspule (5), umfasst, welche für eine Verwendung mit verschiedenen Magnetresonanzanlagen (1) ausgebildet ist, und dass die Magnetresonanzanlage (1) eine, insbesondere fest verbaute, Speichereinrichtung (7) umfasst, in welcher die Frequenzgangdaten (25) für wenigstens einen bestimmten Spulentyp abgelegt sind, wobei
- nach einem Verbinden der tauschbaren Spule (5) mit der Magnetresonanzanlage (1) anhand des Spulentyps automatisch überprüft wird, ob die abgelegten Frequenzgangdaten (25) zu der verbundenen tauschbaren Spule (5) passen, und wenn dies der Fall ist,
- die Frequenzgangkorrektur auf Basis der in der Speichereinrichtung (7) abgelegten Frequenzgangdaten (25) durchgeführt wird.

2. Verfahren nach Anspruch 1, **dadurch gekennzeichnet, dass** die tauschbare Spule (5) einen Datenspeicher (30) umfasst und die Frequenzgangdaten (25) in diesem Datenspeicher (30) der tauschbaren Spule (5) abgelegt werden und zum Durchführen der Frequenzgangkorrektur aus dem Datenspeicher (30) abgerufen werden.

3. Verfahren nach einem der vorhergehenden Ansprüche, **dadurch gekennzeichnet, dass** in einer Datenverarbeitungseinrichtung (6) der Magnetresonanzanlage (1) ein vorgegebenes Modell für die Frequenzgangkorrektur hinterlegt ist und die Frequenzgangdaten (25) dann in Form von Parameterwerten für dieses Modell zum Erfassen bereitgestellt werden.

4. Verfahren nach einem der vorhergehenden Ansprüche, **dadurch gekennzeichnet, dass** die Frequenzgangdaten (25) in Kombination mit den Prescandaten (13) aufgenommen werden, welche zur Korrektur einer räumlichen Empfindlichkeitsvariation bei der Rekonstruktion des Magnetresonanzbildes (18) aus den Magnetresonanzdaten aufgenommen werden.

5. Verfahren nach Anspruch 4, **dadurch gekennzeichnet, dass** eine von der Messsequenz (9) geforderte Bandbreite (f2-f1) ermittelt wird und die Magnetresonanzanlage (1) zum Aufnehmen der Prescandaten (13) so eingestellt wird, dass sich dabei die gleiche Bandbreite (f2-f1) ergibt wie von der Messsequenz (9) gefordert.

6. Verfahren nach einem der Ansprüche 4 und 5, **dadurch gekennzeichnet, dass** ein Bandbreitenschwellenwert vorgegeben wird und die Magnetresonanzanlage (1) nur dann zum Erfassen der Frequenzgangdaten (25) entsprechend der von der Messsequenz (9) geforderten Bandbreite (f2-f1) eingestellt wird, wenn diese geforderte Bandbreite (f2-f1) den Bandbreitenschwellenwert erreicht oder überschreitet.

7. Verfahren nach einem der Ansprüche 4 bis 6, **dadurch gekennzeichnet, dass** mehrere Prescandatensätze (19, 20, 21) mit unterschiedlichen Bandbreiten akquiriert werden und die Frequenzgangdaten (25) für die Frequenzgangkorrektur bei der von der Messsequenz (9) tatsächlich verwendeten Bandbreite (f2-f1) durch Interpolation aus den Prescandatensätzen (19, 20, 21) bestimmt werden.

8. Verfahren nach einem der Ansprüche 1 bis 3, **dadurch gekennzeichnet, dass** die Frequenzgangdaten (25) separat von den Prescandaten (13) aufgenommen werden, wobei anstelle eines vollständigen mit der Messsequenz (9) oder dem Prescan (11, 19, 20, 21) abzubildenden Volumens nur eine gegenüber der Messsequenz (9) beziehungsweise dem Prescan (11, 19, 20, 21) reduzierte Echoanzahl von wenigstens einem Echo, insbesondere höchstens 20 Echos, bevorzugt höchstens 10 Echos, gemessen wird, wobei zumindest eine größte von der Messsequenz (9) geforderte Bandbreite (f2-f1) für das wenigstens eine Echo verwendet wird.

9. Verfahren nach Anspruch 8, **dadurch gekennzeichnet, dass**
- wenigstens ein Referenzecho aufgenommen wird mit einer vorgegebenen ersten Bandbreite (f4-f3), wobei die erste Bandbreite kleiner ist als die zumindest eine größte von der Messsequenz (9) geforderte Bandbreite (f2-f1), wobei das Referenzecho und das wenigstens eine Echo denselben Bildinhalt abbilden, und
- die Frequenzgangdaten (25) durch Vergleich dieser beiden Echos miteinander bestimmt werden, wobei die erste Bandbreite so klein gewählt wird, dass für die Bestimmung der Frequenzgangdaten angenommen werden kann, dass das Referenzecho keine oder kaum eine Frequenzabhängigkeit zeigt.

10. Verfahren nach einem der vorhergehenden Ansprüche, **dadurch gekennzeichnet, dass** zum Bestimmen der Frequenzgangdaten (25) für eine Lokalspule (5) eines Empfangssystems der Magnetresonanzanlage (1) frequenzabhängige Signaldaten sowohl für die Lokalspule (5) als auch für eine Körperspule (4) eines Sendersystems der Magnetresonanzanlage (1) gemessen werden, wobei die Lokalspule (5) breitbandiger ist als die Körperspule (4), und durch Vergleich der Signaldaten miteinander die Frequenzgangdaten (25) für die Lokalspule (5) bestimmt werden, welche frei von einem Einfluss eines Frequenzgangs der Körperspule (5) sind.

11. Verfahren nach einem der vorhergehenden Ansprüche, **dadurch gekennzeichnet, dass** auf einer Senderseite der Magnetresonanzanlage (1) ein bei der Messsequenz (9) auf eine Sendespule (4) gegebenes Signal in Abhängigkeit von den Frequenzgangdaten (25) verzerrt wird und dadurch eine Frequenzabhängigkeit eines Ausgangssignals der Sendespule (4) und/oder eines korrespondierenden mittels einer Empfangsspule der Magnetresonanzanlage (1) gemessenen Signals ausgeglichen wird.

12. Computerlesbares Speichermedium (7), auf dem ein Computerprogramm gespeichert ist, welches Befehle umfasst, die bei einer Ausführung des Computerprogramms (7) durch eine Datenverarbeitungseinrichtung (6) einer Magnetresonanzanlage (1)diese dazu veranlassen, ein Verfahren nach einem der vorhergehenden Ansprüche auszuführen.

13. Magnetresonanzanlage (1) mit einem computerlesbaren Speichermedium (7) nach Anspruch 12.

## Claims

1. Method for improving an image quality of a magnetic resonance image (18), in which
- magnetic resonance data of an examination object (3) is detected, which was recorded by means of a magnetic resonance system (1) according to a predetermined measuring sequence (9), and which is used to reconstruct the magnetic resonance image (18),
- frequency response data (25) for a subsystem (4, 5) of the magnetic resonance system (1) is detected separately from the measuring sequence (9),
- a frequency response correction for the magnetic resonance data or of prescan data (13) is carried out on the basis of the frequency response data (25),
wherein the prescan data (13) is taken into account when reconstructing the magnetic resonance image (18) from the magnetic resonance data,
**characterised in that** the subsystem (4, 5) comprises a replaceable coil (5), in particular a local coil (5), which is embodied for use with different magnetic resonance systems (1) and that the magnetic resonance system (1) comprises a, in particular fixedly installed, storage device (7), in which the frequency response data (25) for at least one specific coil type is stored, wherein
- after connecting the replaceable coil (5) with the magnetic resonance system (1), a check is automatically carried out on the basis of the coil type to determine whether the stored frequency response data (25) matches the connected replaceable coil (5) and if this is the case,
- the frequency response correction is carried out on the basis of the frequency response data (25) stored in the storage device (7).

2. Method according to claim 1, **characterised in that** the replaceable coil (5) comprises a data memory (30), and the frequency response data (25) is stored in this data memory (30) of the replaceable coil (5) and is called up from the data memory (30) in order to carry out the frequency response correction.

3. Method according to one of the preceding claims, **characterised in that** a predetermined model for the frequency response correction is stored in a data processing device (6) of the magnetic resonance system (1) and the frequency response data (25) is then provided in the form of parameter values for this model for detection purposes.

4. Method according to one of the preceding claims, **characterised in that** the frequency response data (25) is recorded in combination with the prescan data (13), which is recorded from the magnetic resonance data in order to correct a spatial sensitivity variation in the reconstruction of the magnetic resonance image (18).

5. Method according to claim 4, **characterised in that** a bandwidth (f2-f1) required by the measuring sequence (9) is determined and the magnetic resonance system (1) is set up in order to record the prescan data (13) so that here the same bandwidth (f2-f1) is produced as is required by the measuring sequence (9).

6. Method according to one of claims 4 and 5, **characterised in that** a bandwidth threshold value is predetermined and the magnetic resonance system (1) is only then set in order to detect the frequency response data (25) according to the bandwidth (f2-f1) required by the measuring sequence (9) if this required bandwidth (f2-f1) reaches or exceeds the bandwidth threshold value.

7. Method according to one of claims 4 to 6, **characterised in that** a number of prescan data records (19, 20, 21) are acquired with different bandwidths, and the frequency response data (25) for the frequency response correction with the bandwidth (f2-f1) actually used by the measuring sequence (9) is determined by interpolation from the prescan data records (19, 20, 21).

8. Method according to one of claims 1 to 3, **characterised in that** the frequency response data (25) is recorded separately from the prescan data (13), wherein instead of a volume to be imaged completely with the measuring sequence (9) or the prescan (11, 19, 20, 21), only an echo number, of at least one echo, in particular at most 20 echoes, preferably at most 10 echoes, which is reduced by comparison with the measuring sequence (9) or the precscan (11, 19, 20, 21), is measured, wherein at least one largest bandwidth (f2-f1) required by the measuring sequence (9) is used for the at least one echo.

9. Method according to claim 8, **characterised in that**
- at least one reference echo is recorded with a predetermined first bandwidth (f4-f3), wherein the first bandwidth is smaller than the at least one largest bandwidth (f2-f1) required by the measuring sequence (9),
wherein the reference echo and the at least one echo map the same image content, and
- the frequency response data (25) is determined by comparing these two echoes with one another, wherein the first bandwidth is selected to be so small that it can be assumed for the determination of the frequency response data that the reference echo shows no or barely any frequency dependency.

10. Method according to one of the preceding claims, **characterised in that** in order to determine the frequency response data (25) for a local coil (5) of a receiving system of the magnetic resonance system (1), frequency-dependent signal data is measured both for the local coil (5) and also for a body coil (4) of a transmitter system of the magnetic resonance system (1), wherein the local coil (5) has a wider broadband than the body coil (4), and by comparing the signal data with one another, the frequency response data (25) is determined for the local coil (5), which is free of an influence of a frequency response of the body coil (5).

11. Method according to one of the preceding claims, **characterised in that** on a transmitter side of the magnetic resonance system (1), a signal provided on a transmit coil (4) during the measuring sequence (9) is distorted as a function of the frequency response data (25) and as a result a frequency dependency of an output signal of the transmit coil (4) and/or a corresponding signal measured by means of a receive coil of the magnetic resonance system (1) is compensated.

12. Computer readable storage medium (7), on which a computer program is stored, which comprises commands, which, when the computer program (7) is executed by a data processing device (6) of a magnetic resonance system (1) trigger this to implement a method according to one of the preceding claims.

13. Magnetic resonance system (1) with a computer-readable storage medium (7) according to claim 12.

## Revendications

1. Procédé d'amélioration de la qualité d'une image (18) de résonnance magnétique, dans lequel
- on saisit des données de résonnance magnétique d'un objet (3) à examiner, qui ont été enregistrées suivant une séquence (9) de mesure donnée à l'avance au moyen d'une installation (1) de résonnance magnétique et qui servent à la reconstruction de l'image (18) de résonnance magnétique,
- séparément de la séquence (9) de mesure, on saisit des données (25) de réponse fréquentielle d'un sous-système (4, 5) de l'installation (1) de résonnance magnétique,
- à l'aide des données (25) de réponse fréquentielle, on effectue une correction de réponse fréquentielle des données de résonnance magnétique ou de données (13) de pré-scan, dans lequel on prend en compte les données (13) de pré-scan, lors de la reconstruction de l'image (18) de résonnance magnétique à partir des données de résonnance magnétique, **caractérisé en ce que** le sous-système (4, 5) comprend une bobine (5) remplaçable, notamment une bobine (5) locale, qui est constituée pour être utilisée avec des installations (1) de résonnance magnétique différentes, et **en ce que** l'installation (1) de résonnance magnétique comprend un dispositif (7) de mémoire, notamment morte, dans laquelle les données (25) de réponse fréquentielle d'au moins un type déterminé de bobine sont mises en mémoire, dans lequel
- après une liaison de la bobine (5) remplaçable à l'installation (1) de résonnance magnétique, on contrôle automatiquement, à l'aide du type de bobine, si les données (25) de réponse fréquentielle mises en mémoire s'adaptent à la bobine (5) remplaçable reliée et, si cela est le cas,
- on effectue la correction de réponse fréquentielle sur la base des données (25) de réponse fréquentielle mises en mémoire dans le dispositif (7) de mémoire.

2. Procédé suivant la revendication 1, **caractérisé en ce que** la bobine (5) remplaçable comprend une mémoire (30) de données et on met les données (25) de réponse fréquentielle dans cette mémoire (30) de données de la bobine (5) remplaçable et, pour effectuer la correction de réponse fréquentielle, on les appelle de la mémoire (30) de données.

3. Procédé suivant l'une des revendications précédentes, **caractérisé en ce qu'**un modèle donné à l'avance de la correction de réponse fréquentielle est mis dans un dispositif (6) de traitement de données de l'installation (1) de résonnance magnétique, et on met à disposition, pour la saisie, les données (25) de réponse fréquentielle ensuite sous la forme de valeurs de paramètre de ce modèle.

4. Procédé suivant l'une des revendications précédentes, en ce que l'on enregistre les données (25) de réponse fréquentielle en combinaison avec les données (13) de pré-scan, que l'on enregistre pour la correction de variation de sensibilité dans l'espace, lors de la reconstruction de l'image (18) de résonnance magnétique à partir des données de résonnance magnétique.

5. Procédé suivant la revendication 4, **caractérisé en ce que** l'on détermine une largeur (f2-f1) de bande exigée par la séquence (9) de mesure et on règle l'installation (1) de résonnance magnétique pour l'enregistrement des données (13) de pré-scan, de manière à obtenir la même largeur (f2-f1) de bande que celle exigée par la séquence (9) de mesure.

6. Procédé suivant l'une des revendications 4 et 5, **caractérisé en ce que** l'on prescrit une valeur de seuil de largeur de bande et on règle l'installation (1) de résonnance magnétique seulement alors pour la saisie des données (25) de réponse fréquentielle d'une manière correspondante à la largeur (f2-f1) de bande exigée par la séquence (9) de mesure, si cette largeur (f2-f1) de bande exigée atteint ou dépasse la valeur de seuil de largeur de bande.

7. Procédé suivant l'une des revendications 4 à 6, **caractérisé en ce que** l'on acquiert plusieurs ensembles (19, 20, 21) de données de pré-scan ayant des largeurs de bande différentes et on détermine, par interpolation à partir des ensembles (19, 20, 21) de données de pré-scan, des données (25) de réponse fréquentielle pour la correction de réponse fréquentielle à la largeur (f2-f1) de bande utilisée réellement par la séquence (9) de mesure.

8. Procédé suivant l'une des revendications 1 à 3, **caractérisé en ce que** l'on enregistre les données (25) de réponse fréquentielle séparément des données (13) de pré-scan, dans lequel on mesure au lieu d'un volume à reproduire complètement avec la séquence (9) de mesure ou le pré-scan (11, 19, 20, 21) seulement un nombre d'échos réduit par rapport à la séquence (9) de mesure ou respectivement le pré-scan (11, 19, 20, 21) d'au moins un écho, notamment d'au plus 20 échos, de préférence d'au plus 10 échos, dans lequel on utilise, pour le au moins un écho, au moins une largeur (f2-f1) de bande la plus grande exigée par la séquence (9) de mesure.

9. Procédé suivant la revendication 8, **caractérisé en ce que**
- on enregistre au moins un écho de référence ayant une première largeur (f4-f3) de bande donnée à l'avance, dans lequel la première largeur de bande est plus petite que la au moins une plus grande largeur (f2-f1) de bande exigée par la séquence (9) de mesure, dans lequel l'écho de référence et le au moins un écho reproduisent le même contenu d'image, et
- on détermine les données (25) de réponse fréquentielle en comparant entre eux ces deux échos, dans lequel on choisit la première largeur de bande si petite que l'on peut admettre, pour la détermination des données de réponse fréquentielle, que l'écho de référence n'a pas ou n'a guère de variabilité en fonction de la fréquence.

10. Procédé suivant l'une des revendications précédentes, **caractérisé en ce que**, pour déterminer les données (25) de réponse fréquentielle d'une bobine (5) locale d'un système de réception de l'installation (1) de résonnance magnétique, on mesure des données de signal en fonction de la fréquence, tant pour la bobine (5) locale, qu'également pour une bobine (4) de corps d'un système d'émetteur de l'installation (1) de résonnance magnétique, la bobine (5) locale étant à bande plus large que la bobine (4) de corps et, en comparant les données de signal entre elles, on détermine les données (25) de réponse fréquentielle de la bobine (5) locale, qui sont exemptes d'une influence d'une réponse fréquentielle de la bobine (5) de corps.

11. Procédé suivant l'une des revendications précédentes, **caractérisé en ce que**, d'un côté d'émetteur de l'installation (1) de résonnance magnétique, on déforme, en fonction des données (25) de réponse fréquentielle, un signal donné lors de la séquence (9) de mesure sur une bobine (4) d'émission et on compense ainsi une variabilité de fréquence d'un signal de sortie de la bobine (4) d'émission et/ou un signal correspondant mesuré au moyen d'une bobine de réception de l'installation (1) de résonnance magnétique.

12. Support (7) de mémoire, déchiffrable par ordinateur, sur lequel est mis en mémoire un programme d'ordinateur, qui comprend des instructions qui, lors d'une réalisation du programme (7) d'ordinateur par un dispositif (6) de traitement de données d'une installation (1) de résonnance magnétique, fait que celle-ci effectue un procédé suivant l'une des revendications précédentes.

13. Installation (1) de résonnance magnétique ayant un support (7) de mémoire déchiffrable par ordinateur suivant la revendication 12.
